# EUROPEAN PATENT APPLICATION

(11) **EP 2 787 635 A1**
(43) Date of publication of application: **08.10.2014**
(21) Application number: 11876774.8
(22) Date of filing: 28.11.2011
(51) Int. Cl.: H03D 7/00

(54) **MULTI-BAND LO SELECTABLE WIDEBAND LNB USING PLL**

(71) Applicant: Intellian Technologies Inc., Seoul 135-010 (KR)
(72) Inventor: LEE, Soo Jin, Hwaseong-si Gyeonggi-do 445-732 (KR); CHA, Seung Hyun, Hwaseong-si Gyeonggi-do 445-170 (KR); JUNG, Jin Woo, Suwon-si Gyeonggi-do 442-847 (KR)
(74) Representative: Qip Patentanwälte Dr. Kuehn & Partner mbB
(86) International application number: PCT/KR2011/009122
(87) International publication number: WO 2013/081197

(57) **Abstract**

The present invention relates to a low noise frequency converter capable of oscillating various frequencies according to the user's selection. The user selects at least one or more frequencies from among a plurality of frequencies. The low noise frequency converter receives a control signal from the user, and oscillates a frequency selected by the user according to the received control signal. The low noise frequency converter uses the oscillated frequencies for frequency conversion.

## Description

### Technical Field

The present invention relates to an apparatus for converting a frequency, and more particularly, to a frequency conversion apparatus for conveniently converting a frequency without location restrictions by generating various frequencies based on a selection of a user.

### Background Art

A broadcast and communication system may transmit and receive data using a high frequency signal. A broadcast and communication apparatus that transmits data may modulate data of a base band to be in a high frequency band, and transmit the modulated data. A broadcast and communication apparatus that receives data may convert a high frequency signal into an intermediate frequency band signal using a local signal, and decode the converted signal.

Each country may use a different frequency band. Thus, a broadcast and communication apparatus that receives only one frequency band may not receive a broadcast and communication signal transmitted from another country.

To solve this, ships and travelers moving through various countries need to prepare a plurality of broadcast and communication apparatuses for each country to receive the broadcast and communication signal from a corresponding country. Alternatively, the ships and travelers prepare a plurality of low noise frequency converters appropriate for various countries and change the low noise frequency converter included in a broadcast and communication apparatus when moving to another country.

Preparing the plurality of broadcast and communication systems or the plurality of frequency converters for various countries is a major inconvenience to the ships and travelers. Accordingly, there is a desire for a broadcast and communication apparatus or a low noise frequency converter that may change a frequency band to receive a broadcast and communication signal based on a selection of a user.

### Disclosure of Invention

### Technical Goals

An aspect of the present invention provides an apparatus for generating a local signal based on a selection of a user.

Another aspect of the present invention also provides an apparatus for converting a frequency using a local signal appropriate for a local frequency environment without location restrictions.

### Technical Solutions

According to an aspect of the present invention, there is provided a low noise frequency converter including a control signal receiver to receive a control signal determined based on a region in which the low noise frequency converter operates, a frequency determiner to determine a frequency of a local signal in response to the control signal, and a wideband phase-locked loop (PLL) local signal generator to generate the local signal corresponding to the determined frequency.

According to another aspect of the present invention, there is also provided a low noise frequency conversion method including receiving a control signal determined based on a region in which a low frequency converter operates, determining a frequency of a local signal in response to the control signal, and generating the local signal corresponding to the determined frequency.

### Advantageous Effects

According to an aspect of the present invention, it is possible to generate a local signal of an appropriate frequency based on a selection of a user and thus, convert a frequency using the local signal appropriate for a local frequency environment without restrictions on a location.

According to another aspect of the present invention, it is possible to generate a local signal using a single low noise frequency converter without restrictions on a location and thus, a user may conveniently receive a broadcast and communication signal without a need to change a low noise frequency converter for each region.

### Brief Description of Drawings

FIG. 1 is a block diagram illustrating a configuration of a low noise frequency converter according to an embodiment of the present invention.
FIG. 2 is a block diagram illustrating a configuration of a wideband phase-locked loop (PLL) local signal generator according to an embodiment of the present invention.
FIG. 3 is a flowchart illustrating a low noise frequency conversion method in a stepwise manner according to an embodiment of the present invention.
FIG. 4 is a flowchart illustrating a local signal generation method in a stepwise manner according to an embodiment of the present invention.

### Best Mode for Carrying Out the Invention

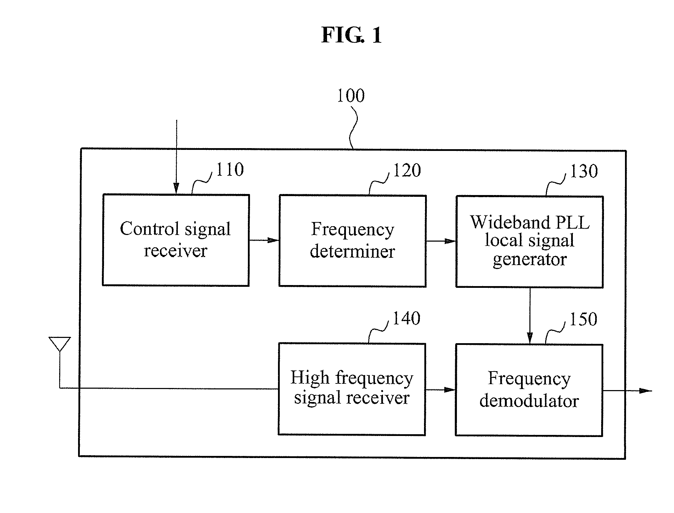

FIG. 1 is a block diagram illustrating a configuration of a low noise frequency converter according to an embodiment of the present invention. In an example embodiment, a low noise frequency converter 100 may include a control signal receiver 110, a frequency determiner 120, a wideband phase-locked loop (PLL) local signal generator 130, a high frequency signal receiver 140, and a frequency demodulator 150.

The control signal receiver 110 may receive a control signal determined based on a region in which the low noise frequency converter 100 operates. In an aspect, the low nose frequency converter 100 may convert a satellite signal of a high frequency band into a satellite signal of an intermediate frequency band. In this case, the control signal may include information on a frequency of the high frequency band received by the low noise frequency converter 100.

In an aspect, a user may determine a local signal to be generated by the low noise frequency converter 100, and directly input a control signal corresponding to the determined local frequency using a user interface such as a button, a touch screen, and the like. In another aspect, the control signal receiver 170 may receive, from another device, the control signal using a digital communication method, an analog communication method, a digital satellite equipment control (DiSEqC) communication method and the like.

The DiSEqC communication method indicating the digital satellite equipment control communication method may be a communication method of controlling digital satellite equipment. The DiSEqC communication method may be used to control a peripheral device connected to a coaxial cable in a satellite set-top box of a general satellite broadcast and communication system.

In general, a frequency converter may receive two control signals of 13 volts (V)/18 V and thus, select two local bands. When the DisEqC communication method is used, a 22 kilohertz (kHz) tone signal may be transmitted along with the two control signals of 13 V/18 V. Thus, the frequency converter may receive four control signals of 13 V/18 V/13 V- DiSEqC/18 V- DisEqC and thus, select four local signals.

The frequency determiner 120 may determine a frequency of the local signal in response to the control signal. In general, a frequency of a satellite signal may vary based on the region in which the low noise frequency converter 100 operates. However, a frequency of the intermediate frequency band may not pertain to a region. The local signal may be determined based on a difference between a value of the frequency of the high frequency band and a value of the frequency of the intermediate frequency band.

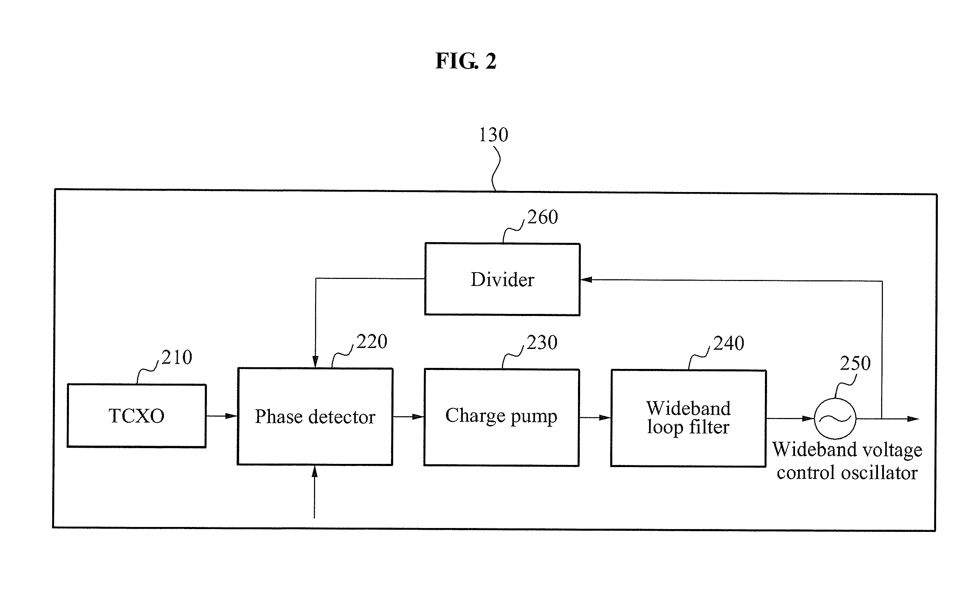

The wideband PLL local signal generator 130 may generate the local signal corresponding to the frequency determined by the frequency determiner 120. Descriptions about a configuration for generating the local signal will be provided with reference to FIG. 2.

The high frequency signal receiver 140 may receive a broadcast and communication signal transmitted through a modulation into a high frequency signal. In an aspect, the high frequency signal received by the high frequency signal receiver 140 may be a broadcast signal received from a satellite.

The frequency demodulator 150 may demodulate the broadcast and communication signal to be an intermediate frequency band signal using the local signal.

FIG. 2 is a block diagram illustrating a configuration of a wideband PLL local signal generator according to an embodiment of the present invention. The wideband PLL local signal generator 130 may include a temperature compensated crystal oscillator (TCXO) 210, a phase detector 220, a charge pump 230, a wideband loop filter 240, a wideband voltage control oscillator 250, and a divider 260.

The TCXO 210 may also refer to a temperature compensated X-tal oscillator. The TCXO 210 may generate a predetermined reference signal irrespective of a change in an ambient temperature. The TCXO 210 may generate a reference signal having a low frequency, for example, approximately 10 megahertz (MHz).

In an example embodiment, to enhance a phase noise characteristic of a local signal, a crystal oscillator having a high phase noise characteristic may be used as the TCXO 210.

The phase detector 220 may compare a phase of the reference signal and a phase of a feedback signal, and generate a differential signal corresponding to a difference between the two signals. In an aspect, a frequency of the reference signal may differ from a frequency of the feedback signal. In this case, the phase detector 220 may divide the reference signal and the feedback signal, convert each of the reference signal and the feedback signal to be positioned in a similar frequency band and then, compare a phase of the converted reference signal and a phase of the converted feedback signal.

When the difference between the frequency of the reference signal and the frequency of the feedback signal is relatively small, a degree of a change in the phase of the reference signal may differ from a degree of a change in the phase of the feedback signal in a process of time. Thus, by comparing the phase of the reference signal and the phase of the feedback signal, a difference between the reference signal and the feedback signal may be acquired. The phase detector 220 may observe whether the phase of the reference signal is identical to the phase of the feedback signal, and identical phases are maintained, to generate a differential signal.

In an aspect, the phase detector 220 may generate a pulse having a width proportional to the difference in the phases of the two signals, as the differential signal. Thus, when the difference between the phases of the two signals is relatively large, a pulse having a large width may be generated as the differential signal. When the difference in the phases of the two signals is relatively small, a pulse having a small width may be generated as the differential signal.

Also, the phase detector 220 may change the differential signal in response to a control signal input by a user. For example, the phase detector 220 may arbitrarily adjust a width of a pulse by adjusting a divisor value fed back using a divider. In this case, the divisor value fed back to adjust the width of the pulse may be determined in response to the control signal.

The charge pump 230 may pump an analog current proportional to the width of the pulse generated by the phase detector 220. For example, when the difference between the phases of the two signals is relatively large, the width of the pulse may be large, and an amount of charge accumulated in the charge pump may also be large such that an analog voltage value is correspondingly large.

The wideband loop filter 240 may generate an oscillator control signal based on the analog voltage value output from the charge pump. Thus, a voltage of the oscillator control signal generated by the wideband loop filter 240 may be proportional to the difference between the phases of the two signals. Also, the voltage of the oscillator control signal generated by the wideband loop filter 240 may be determined in response to the control signal input by the user.

In an aspect, the wideband loop filter 240 may be implemented to be a low pass filter so as to remove noise occurring in a process of an operation. The wideband loop filter may be implemented using an operational amplifier (OP-Amp).

The wideband voltage control oscillator 250 may generate a local signal of a frequency proportional to the voltage of the oscillator control signal generated by the wideband loop filter 240. In an aspect, an increase in the frequency of the local signal may be linearly proportional to the voltage of the oscillator control signal.

The divider 260 may divide the generated local signal. A portion of the divided local signal may be input to the phase detector 220 as the feedback signal. Another portion of the divided local signal may be used to convert a frequency of a high frequency band. In an aspect, the other portion of the divided local signal may be divided based on a predetermined multiple so as to multiply a frequency thereof. The multiplied local signal may be used to convert a frequency of a high frequency signal.

In an example embodiment, although in a case in which a single low noise frequency converter is used, the user may directly input, from an external area, a signal corresponding to a local signal of a frequency of a corresponding region, the signal may be converted into a control signal using, for example, a digital communication method, an analog communication method, and a DiSEqC communication method and received by the low noise frequency converter, and in response to the received control signal, the local signal generator may be controlled to generate a local signal of a user desiring frequency. Since the user may generate a wideband PLL local signal that may receive a broadcast and communication signal using the single low noise frequency converter without restrictions on a location, the user may conveniently receive the high frequency signal without a need to change the low noise frequency converter for each region.

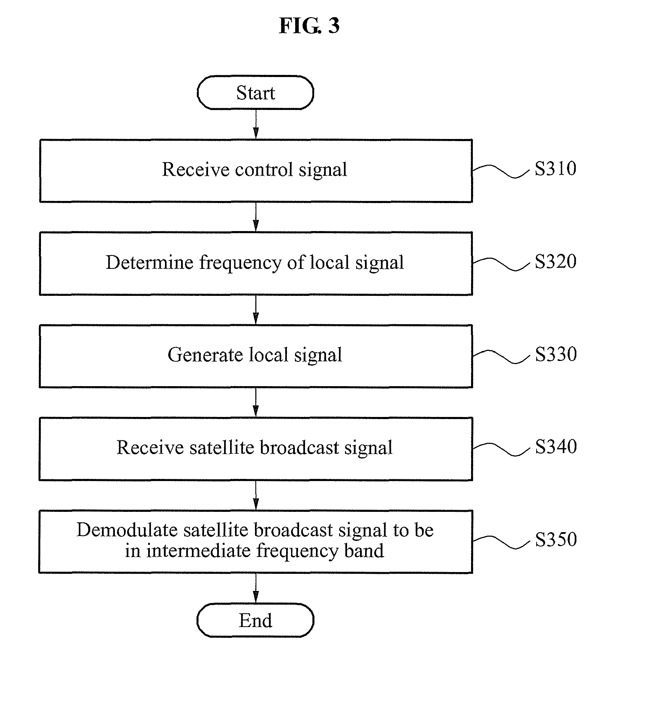

FIG. 3 is a flowchart illustrating a low noise frequency conversion method in a stepwise manner according to an embodiment of the present invention.

In operation S310, a low noise frequency converter may receive a control signal. The low noise frequency converter may receive a broadcast and communication signal of a high frequency band to convert a frequency of the broadcast and communication signal to be an intermediate band frequency. The frequency of the broadcast and communication signal may vary for each region. For example, a frequency of a broadcast and communication signal used in a North American region may differ from frequency of a broadcast and communication signal used in European or Asian regions. In this example, the control signal may include information on a high frequency band to be converted by the low noise frequency converter.

In an aspect, the user may determine a local signal to be generated by the low noise frequency converter 100. In this case, in operation S310, the low noise frequency converter may directly receive a control signal corresponding to a local frequency determined by the user, using a user interface such as a button, a touch screen, and the like. In another aspect, in operation S310, the low noise frequency converter may receive, from another device, the control signal using a digital communication method, an analog communication method, a DiSEqC communication method, and the like.

In operation S320, the low noise frequency converter may determine the frequency of the local signal in response to the control signal. In an aspect, the frequency of the local signal may correspond to a difference between the received frequency of the high frequency band and the frequency of the intermediate frequency band. In general, since the frequency of the intermediate band may be uniform irrespective of a region in which the low noise frequency converter operates, the frequency of the local signal may be determined based on the region in which the low noise frequency converter operates.

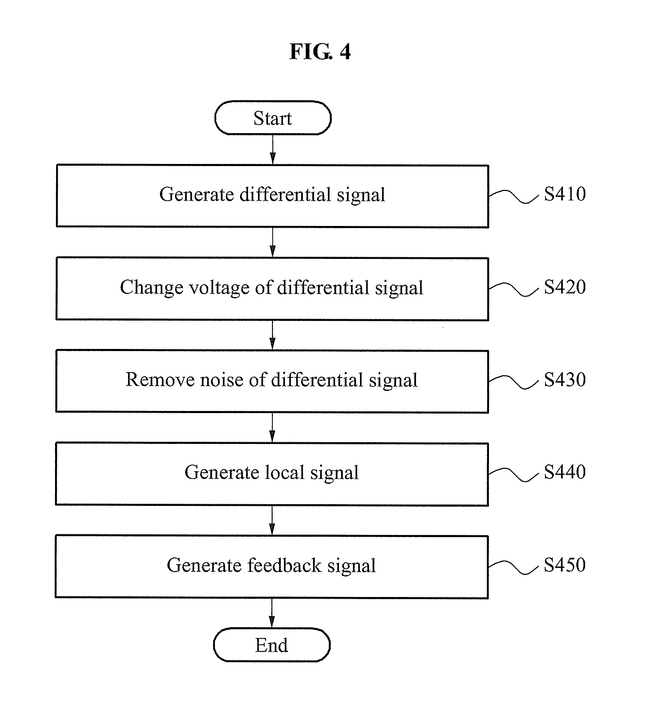

In operation S3330, the low noise frequency converter may generate a local signal corresponding to the determined frequency. Descriptions about a configuration for generating the local signal will be provided with reference to FIG. 4.

In operation S340, the low noise frequency converter may receive the broadcast and communication signal. In an aspect, the broadcast and communication signal received by the low noise frequency converter may be a broadcast signal of a high frequency band received from a satellite.

In operation S350, the low noise frequency converter may demodulate the broadcast signal to be an intermediate frequency band signal.

FIG. 4 is a flowchart illustrating a local signal generation method in a stepwise manner according to an embodiment of the present invention.

In operation S410, a low noise frequency converter may generate a differential signal. In an aspect, the low noise frequency converter may generate the differential signal by comparing a phase of a reference signal and a phase of a feedback signal.

The reference signal may be a signal of a predetermined frequency generated irrespective of a change in an ambient temperature, and generated using a temperature compensated crystal oscillator. Also, the feedback signal may be a signal generated by dividing a local signal.

In an aspect, a frequency of the reference signal may differ from a frequency of the feedback signal. In this case, the low noise frequency converter may divide the reference signal and the feedback signal to convert each of the two signals to be positioned in a similar frequency band, and compare the converted phase of the reference signal and the converted phase of the feedback signal.

When the difference between the frequency of the reference signal and the frequency of the feedback signal is relatively small, a degree of a change in the phase of the reference signal may differ from a degree of a change in the phase of the feedback signal in a process of time. Thus, by comparing the phase of the reference signal and the phase of the feedback signal, a difference between the reference signal and the feedback signal may be acquired. The low noise frequency converter may observe whether the phase of the reference signal is identical to the phase of the feedback signal, and identical phases are maintained, to generate a differential signal.

In an aspect, the low noise frequency converter may generate a pulse having a width proportional to the difference in the phases of the two signals, as the differential signal. Thus, when the difference between the phases of the two signals is relatively large, a pulse having a large width may be generated as the differential signal. When the difference in the phases of the two signals is relatively small, a pulse having a small width may be generated as the differential signal.

In operation S420, the low noise frequency converter may change the differential signal in response to a control signal input by a user. For example, the low noise frequency converter may arbitrarily adjust a width of a pulse by adjusting a divisor value of the feedback signal. In this case, the divisor value of the feedback signal may be determined in response to the control signal.

In operation S420, the low noise frequency converter may pump an analog current proportional to the width of the generated pulse. For example, when the difference between the phases of the two signals is relatively large, the width of the pulse may be large, and an amount of charge accumulated in the charge pump may also be large such that an analog voltage value is correspondingly large.

In operation S430, the low noise frequency converter may generate an oscillator control signal by removing noise from an analog voltage. The low noise frequency converter may remove the noise from the analog voltage using a wideband loop filter. The low noise frequency converter may generate the oscillator control signal to be proportional to the difference between the phase of the reference signal and the phase of the feedback signal.

In operation S440, the low noise frequency converter may generate a local signal of a frequency proportional to the voltage of the oscillator control signal. In an aspect, an increase in the frequency of the local signal may be linearly proportional to the voltage of the oscillator control signal.

In operation S450, the low noise frequency converter may generate the feedback signal. In an aspect, the low noise frequency converter may divide the feedback signal by dividing a portion of the generated local signal. The generated feedback signal may be used to generate the differential signal in operation S410. Another portion of the divided local signal may be used to convert frequencies of the broadcast and communication signal of the high frequency band. In an aspect, the other portion of the local signal may be divided based on a predetermined multiple so as to multiply a frequency thereof. The multiplied local signal may be used to convert a frequency of a high frequency signal.

In an example embodiment, although in a case in which a single low noise frequency converter is used, a local signal of a user desiring a frequency may be automatically generated in response to a control signal input by the user from an external area. Since the user may generate the local signal using the single low noise frequency converter without restrictions on a location, the user may conveniently receive a high frequency signal without a need to change the low noise frequency converter for each region.

## Claims

1. A low noise frequency converter comprising:
a control signal receiver to receive a control signal determined based on a region in which the low noise frequency converter operates;
a frequency determiner to determine a frequency of a local signal in response to the control signal; and
a wideband phase-locked loop (PLL) local signal generator to generate the local signal corresponding to the determined frequency.

2. The converter of claim 1, wherein the control signal receiver receives the control signal using at least one of a digital communication method, an analog communication method, and a digital satellite equipment control (DiSEqC) communication method.

3. The converter of claim 1, wherein the wideband PLL local signal generator comprises a phase detector to generate a differential signal by comparing a phase of a reference signal and a phase of a feedback signal, and changes the differential signal in response to the control signal, a wideband voltage control oscillator to generate the local signal of a frequency corresponding to the local signal, and a divider to generate the feedback signal by dividing the local signal.

4. The converter of claim 3, further comprising:
a wideband loop filter to remove noise from the changed differential signal,
wherein the wideband voltage control oscillator generates the local signal by changing the frequency to correspond to an output voltage of the wideband loop filter.

5. A low noise frequency conversion method comprising:
receiving a control signal determined based on a region in which a low frequency converter operates;
determining a frequency of a local signal in response to the control signal; and
generating the local signal corresponding to the determined frequency.

6. The method of claim 5, wherein the receiving comprises directly receiving the control signal corresponding to the local signal of the frequency of the region or receiving the control signal using at least one of a digital communication method, an analog communication method, and a digital satellite equipment control (DiSEqC) communication method, and
wherein the generating comprises generating the local signal in response to the received control signal.

7. A non-transitory computer-readable medium comprising a program for instructing a computer to perform the method of any one of claims 5 and 6.
